# EUROPEAN PATENT APPLICATION

(11) **EP 1 600 691 A1**
(43) Date of publication of application: **30.11.2005**
(21) Application number: 04388032.7
(22) Date of filing: 05.05.2004
(51) Int. Cl.: F21Y 101/02, F21S 8/02, F21V 5/04

(54) **Lamps and lamp assemblies**

(71) Applicant: Lumodan ApS, 1879 Frederiksberg C (DK)
(72) Inventor: Markussen, Brian, 1879 Frederiksberg (DK)
(74) Representative: Nielsen, Henrik Sten

(57) **Abstract**

A lamp includes a light source with a printed circuit board defining planar parallel first and second surfaces, the first surface of the printed circuit board including solder pads for providing electrical connections to a power source, and a light emitting diode mounted on the first side of the printed circuit board, the light emitting diode emitting light within a specific wavelength interval, the light emitting diode being electrically connected to the solder pads. The light source also comprises a heat sink having a planar surface, the first side of the heat sink being mounted on the second surface of the printed circuit board, the heat sink being in thermal communication with the light emitting diode. Furthermore, the light source comprises a first lens mounted on the first surface of the printed circuit board covering the light emitting diode, and a second lens defining first and second opposite sides, the second lens including a recess adapted for receiving the first lens at the first side thereof, the recess receiving the concentrated light, and the second lens further providing a distribution of the concentrated light in a specific distribution at the second side of the second lens.

## Description

The present invention relates to lamps and lamp assemblies. Specifically the present invention relates to lamps preferably built into ceilings, walls or floors. These kinds of lamps or lamp assemblies are sometimes referred to as recessed lighting fixtures. Alternatively the lamps or lamp assemblies may be included in an housing that may be fastened to e.g. a ceiling, wall, floor, a cupboard, a shelf or the like.

Existing lamps, e.g. halogen lamps, have several disadvantages such as high generation of excess heat and high power consumption. The present invention provides a lamp or lamp assembly that may replace an existing halogen lamp, i.e. a lamp or lamp assembly according to the present invention may directly replace a halogen lamp installed as a down light placed in a ceiling.

The excess heat generated in the halogen lamps may ignite material found above ceilings, such as lagging, i.e. insulating material, if not properly installed. Therefor a need for providing a lamp or lamp assembly having a lower generation of heat exists.

An object of the present invention is to provide a lamp or lamp assembly generating less heat, and a lower loss of electrical energy, while maintaining a desired, specific emission of light.

The above need and advantage together with numerous objects, advantages and features which will be evident from the below detailed description of a preferred embodiment of the lamp according to the present invention are according to a first aspect of the present invention obtained by a lamp that includes:
a light source comprising:
   a printed circuit board defining planar parallel first and second surfaces, the first surface of the printed circuit board including solder pads for providing electrical connections to a power source,
   a light emitting diode mounted on the first side of the printed circuit board, the light emitting diode emitting light within a specific wavelength interval, the light emitting diode being electrically connected to the solder pads,
   a heat sink having a planar surface, the first side of the heat sink mounted on the second surface of the printed circuit board, the heat sink being in thermal communication with the light emitting diode,
   a first lens mounted on the first surface of the printed circuit board covering the light emitting diode, the first lens substantially concentrating the light emitted from the light emitting diode so that the concentrated light emitted is substantially perpendicular to the first surface of the printed circuit board,
a second lens defining first and second opposite sides, the second lens including a recess adapted for receiving the first lens at the first side thereof, the recess receiving the concentrated light, and
the second lens providing a distribution of the concentrated light in a specific distribution at the second side of the second lens.

The above need and advantage together with numerous objects, advantages and features which will be evident from the below detailed description of a second embodiment of the lamp according to the present invention are according to a second aspect of the present invention obtained by a lamp that includes:
a light source comprising:
   a printed circuit board defining planar parallel first and second surfaces, the first surface of the printed circuit board including solder pads for providing electrical connections to a power source,
   a light emitting diode mounted on the first side of the printed circuit board, the light emitting diode emitting light within a specific wavelength interval, the light emitting diode being electrically connected to the solder pads,
   a heat sink having a planar surface, the first side of the heat sink mounted on the second surface of the printed circuit board, the heat sink being in thermal communication with the light emitting diode,
   a first lens mounted on the first surface of the printed circuit board covering the light emitting diode, the first lens substantially concentrating the light emitted from the light emitting diode so that the concentrated light emitted is substantially perpendicular to the first surface of the printed circuit board,
a second lens defining first and second opposite sides, the second lens including a recess adapted for receiving the first lens at the first side thereof, and
an adhesive for fixating the light source relative to the second lens at the first side thereof, the recess receiving the concentrated light, the second lens providing a distribution of the concentrated light in a specific distribution at the second side of the second lens.

The printed circuit board is preferably hexagonal, with six rectilinear sides and including millings or bores at the intersections of the rectilinear sides, thereby defining a geometry resembling a star. Alternatively the printed circuit board may have an overall geometrical configuration other that hexagonal, e.g. triangular, square, rectangular, round, circular, oblong, elliptical, pentagonal, heptagonal or any geometrical configuration including a plurality of rectilinear sides or any combination of the above mentioned geometrical configurations.

The light emitting diode has the advantage of having a high emission of light while having a low generation of heat. This results in a light source that saves power while providing a suitable light for both indoor and outdoor lighting.

In the present context the term light emitting diode is considered covering an assembly of a semiconductor element capable of emitting light, a housing wherein the semiconductor element is mounted and a transparent window included in the housing. The transparent window may be constituted by the first lens.

In an alternative embodiment the semiconductor element may be bonded directly to the printed circuit board and the first lens may encapsulate the semiconductor element constituting the light emitting diode.

The light emitted from the light emitting diode depends on the specific semiconductor element, e.g. GaN, GaP and GaAs₁₋ₓPₓ are relevant semiconductor material for light emitting diodes required for emitting short wavelength light, i.e. ultraviolet and most of the visible spectrum. These materials are often doped with elements that serve to enhance radioactive recombination by acting as recombination centres.

The light emitting diode or semiconductor element may be included in a housing for protecting the semiconductor element constituting the light emitting diode and for providing access to larger electrical connectors, as compared to connecting electrical wires directly to the surface of the light emitting diode from the solder pads on the printed circuit board. The light emitting diode is connected to anode and cathode leads by bonding metallic or other electrically conductive wires to the semiconductor element, alternatively the leads are bonded directly to the semiconductor element.

The housing for the light emitting diode may include a slug or heat sink for conducting heat away from the light emitting diode. The heat sink may be mounted so that a part of it may connect to the printed circuit board. A thermal conductive glue or paste may be applied between the heat sink and the printed circuit board, as well as between the printed circuit board and the heat sink mounted on the backside thereof.

It is an object of the present invention to provide a lamp or lamp assembly where the wavelength interval defines light of a substantially white or yellow colour. A lamp or lamp assembly emitting a light being substantially white, warm white or yellow have shown to give the most pleasing lighting. The lamp may, however, emit light being substantially white, warm white, green, cyan, blue, royal-blue, red, red-orange, amber or any colour at any wavelength within the visible spectrum, i.e. substantially within 400-700 Nm.

The light emitting diode may be placed in a reflector structure. The reflector structure may be parabolic, hyperbolic, truncated inverted pyramid, include planar side surfaces and the reflector structure may be shallow or deep. The reflector structure may be constituted by walls forming a trench wherein the light emitting diode is placed.

The heat sink may preferably have an overall circumference corresponding to the outer circumference of the printed circuit board, but may alternatively have a different geometry, such as square, rectangular, oblong, elliptical, round, triangular, pentagonal, hexagonal, heptagonal, or any combination thereof.

The surface opposite the planar surface of the heat sink may define any outer surface, such as planar, rounded, conical, ribbed, finned, bumped, dented, spherical, taper, hyperbola or any combination or combinations thereof for increasing the surface of the heat sink.

The printed circuit board may be single layer or double layer, and may include through plating for conducting heat away from the light emitting diode. A heat conductive paste may be included between the printed circuit board and the light emitting diode.

The solder pads on the printed circuit board may be placed symmetrically around the light emitting diode or close together. E.g. if the printed circuit board is square or rectangular, the solder pads may be placed on the same side, on opposite sides or adjacent sides, while if the printed circuit board is triangular, the solder pads may be places on the same side or on subtending sides. The printed circuit board may include several solder pads for connecting a plurality of light emitting diodes in parallel or series.

The second lens may constitute an optical element for concentrating the light emitted by the light source, an element for allowing the light emitted by the light source to pass substantially without alterations or an optical element for spreading the light emitted by the light source. The second lens may be convex or concave depending on the lighting characteristics that is desired. Also the refractive index of the material used for the second lens has an influence on the distribution of light at the surface of the second lens where the light exists. Further alternatively the second lens may be constituted by a plate mounted in a distance from the light source.

According to a third aspect of the present invention the second lens may further alternatively include a specific recess or a plurality of recesses for receiving a plurality of light sources, such as three light sources. The internal reflection in the lens may then be utilised to achieve a specific light distribution, as the specific recess and/or the plurality of recesses may be configured so as to provide a specific symmetrical or unsymmetrical light distribution.

The second lens is preferably clear or transparent and may include a diffusing surface. Alternatively the glass may be opaque or translucent, so-called milk glass. Further alternatively the second lens may include a plurality of elements defining a multiplicity of light-passing holes. Yet further alternatively the lens may include colouring elements.

The printed circuit board of the lamp or lamp assembly is preferably bonded to the second lens by means of an adhesive. The adhesive may exhibit heat conductive capabilities.

The adhesive may be cured by light or heat.

In the lamp, or lamp assembly, according to the present invention the second lens is made from an optical grade acrylic plastic.

The lamp or lamp assembly according to the present invention may further comprise an electrical transformer connectable to an AC mains supply, such as a 110V 60Hz or 230V 50Hz mains supply, for transforming electrical power supplied from the mains supply to 10 V DC current.

The lamp or lamp assembly may include means for dimming, e.g. either by DC dimming or Pulse Width Modulation (PWM) dimming. PWM modulation is achieved by applying pulses of current and by varying the periods with/without current a specific lighting level may be achieved.

Further the transformer may be connectable to a transformer in an existing installation, previously used to power a halogen lamp.

The lamp or lamp assembly may include no lens, a convex lens, a collimator, a reflector, a light guide, a diffuse reflector or any combination thereof. The light emitting diode may radiate light in a pattern such as lambertian, batwing or the light may be emitted from the side of the light emitting diode. Also, any combination of the lenses and optics mentioned above with any of the radiation patterns also mentioned above is possible.

The present invention is now to be described in detail, with reference to the drawings in which,
Fig. 1 is a schematic perspective view of the front side of a lamp according to the present invention,
Fig. 2 is a schematic perspective view of the backside of the lamp of Fig. 1,
Fig. 3a is a schematic perspective view of a lens and a light source of the lamp of Fig. 1,
Fig. 3b is a schematic perspective view of an alternative lens for a lamp according to the present invention,
Fig. 4 is a schematic perspective view of an alternative embodiment of a lens and a light source of a lamp according to the present invention, and
Fig. 5 is a schematic perspective exploded view of the backside of the lamp of Figs. 1 and 2.

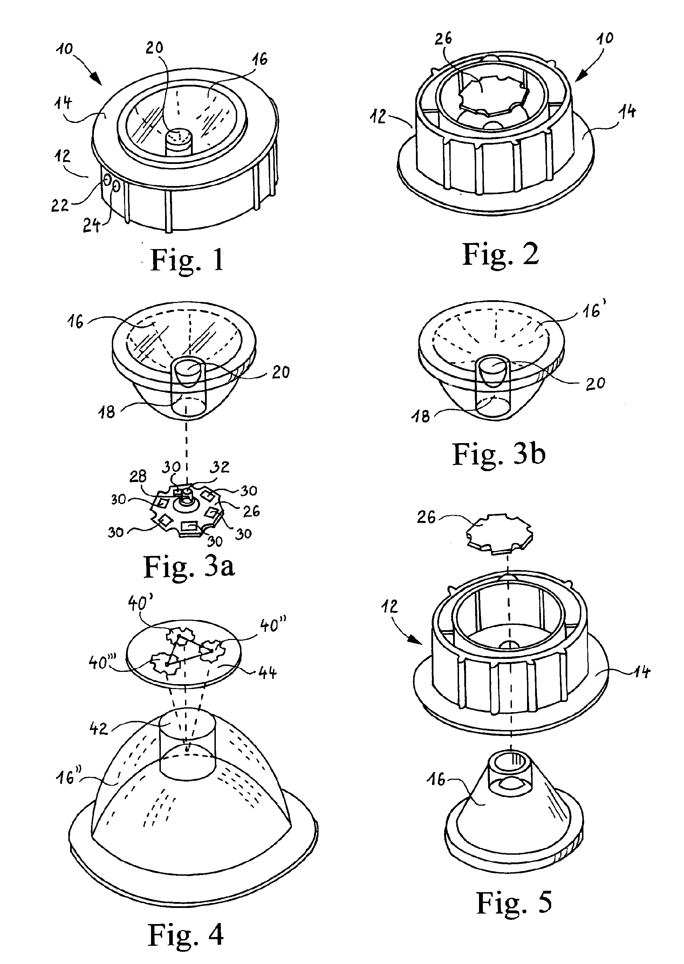

In Fig. 1 a lamp, in its entirety designated the reference numeral 10, is illustrated. In the present context the term lamp is to be considered covering light sources placed or mounted in floors, walls, ceilings or roofs, also lamps mounted in housings that may be fastened to walls, ceilings, roofs, shelves or cupboards are considered part of the present invention.

The down light or lamp 10 comprises a housing 12 having a circumferential encircling flange 14 partly for providing a aesthetic surface when the lamp 10 is mounted in a hole in a floor, wall, ceiling or roof, and partly for providing covering for any imperfect closure or gap between the housing and the hole created in the surface in which the lamp 10 is mounted. Such an open gap may permit moisture to cause damage to the structure in which the lamp 10 is mounted.

The housing 12 may further comprise a backwardly extending part for protecting the lens 16 and for providing a better fastening to e.g. wall plates or ceiling plates. Also fastening means may be connected to the backwardly extending part, e.g. constituted by springs for engaging the backside of ceiling plates, and thereby holding the lamp 10 in its desired position, meanwhile ensuring that the flange is closely held to the ceiling or wall.

The housing 12 may further be included in an external housing, e.g. for mounting on a wall or ceiling. This embodiment may be advantageous for users who does not wish to create holes in walls or ceilings, or who wishes to mount a lamp underneath a top cupboard, wall cupboard or shelf.

The housing 12 may be formed as an integral part, e.g. cast to be a single unitary material, or may be formed by assembling two or more parts, e.g. a metallic back part and a plastic part 14 for providing an aesthetic outer surface.

In the housing 12 a lens 16 is mounted. The lens 16 may act as a light concentrator, light spreader or light diffuser. In the presently preferred embodiment of the present invention, the lens 16 is a solid glass construction having at its centre at the bottom a recess 18 for receiving a light source. The recess 18 may include a reflecting surface 20 for reflecting the light emitted by a light source received within the recess 18. Alternatively, and preferably, the surface 20 is shaped so that the light emitted by the light source is distributed, i.e. the surface 20 is shaped as a lens.

The lens 16 is preferably clear or transparent and may include a diffusing surface. Alternatively the lens 16 may be opaque or translucent, so-called milk glass. Further alternatively the lens may include a plurality of elements defining a multiplicity of light-passing holes. Yet further alternatively the lens may include colouring.

The embodiment illustrated in Fig. 1 includes two holes 22 and 24. The holes 22 and 24 may be utilised as heat conductors or for allowing electrical conductive wires to connect the light source with an external power source.

The power source is preferably constituted by a mains supply and a transformer. The mains supply may vary from country to country, e.g. in Denmark the mains supply supplies 230V at 50 Hz while in the United States the mains supply supplies 110V at 60Hz. Preferably the transformer may be able to connect and transform the electrical current from all ranges of mains supplies.

In houses or installations where the lamp according to the present invention is to replace an existing installation, such as a halogen lamp, the transformer may be of a type capable of receiving electrical current or power from a transformer originally designed for supplying an halogen lamp.

Fig. 2 is an elevated schematic view of the backside of the down light 10 of Fig. 1. In the presently preferred embodiment of the present invention the light source is constituted by a star shaped circuit board 26 whereon a light emitting diode is mounted. The light source assembly will be discussed in detail with reference to Fig. 3. The circuit board 26 may include a heat sink for dissipating excess heat generated in the light source. The heat sink is preferably made from a metallic substance, such as aluminium or copper. The heat sink is mounted at the backside of the printed circuit board 26 and is in the presently preferred embodiment of the present invention shaped similar to the printed circuit board 26. The thickness of the heat sink is approximately 0,5 -1 mm.

In the presently preferred embodiment of the present invention the heat sink comprised two substantially planer parallel surfaces. Embodiments wherein one planer and one non-planer surface occur may be envisioned, e.g. the surface facing away from the printed circuit board 26 may define a spherical, cone, taper, hyperbola, any other geometrical configuration or any combinations of the above mentioned geometrical configuration. The reason for choosing a surface not being planer is to achieve a lager surface for enabling more heat to be dissipated.

The circuit board 26 may have an overall geometrical configuration other that star shaped, e.g. square, rectangular, round, oblong, triangular, elliptical or any combination there of. Further alternatively the printed circuit board 26

The circuit board 26 is preferably fastened to the lens 16 by applying an adhesive between the circuit board 26 and the lens 16. The adhesive may be cured by exposing it to heat or preferably light at a specific wavelength.

The housing 12 includes protruding ribs that may engage the sides of the hole made in the surface whereon the down light 10 is to be mounted. Although not illustrated, the housing may include fasteners, such as springs with extending parts for engaging the backside of e.g. a ceiling sheet or the like.

Fig. 3a is a schematic perspective view of a lens 16 and a light source constituted by a light emitting diode 28 mounted on the printed circuit 26. The printed circuit board 26 includes a plurality of solder pads 30. The light emitting diode 28 is fitted with a lens 32, in the presently preferred embodiment of the present invention, the lens 32 is a high dome or hemispherical dome. Alternatively the lens 32 may be a low dome.

The lens 16 may be shaped as a collimator for directing the light out of the lamp10. The recess 18 is shaped as a small tube or cylinder for receiving the dome or lens 32. The material used to form the lens 16 may be optical grade acrylic or other suitable material.

Fig. 3b illustrates an alternative lens 16' having a concave inner surface for providing a specific distribution of light.

The light emitting diode 28 may emit light at a variety of wave lengths, such that the light emitted from the light emitting diode 28 may be predominantly: white, warm white, green, cyan, blue, royal-blue, red, red-orange, amber or any colour at any wavelength within the visible spectrum, i.e. substantially within 400-700 Nm.

In the presently preferred embodiment of the present invention, the light source is supplied from the company Lumileds Lighting.

In Fig. 4, an alternative embodiment of a lens 16' and an alternative embodiment of a light source are illustrated. The alternative light source comprises 3 light emitting diode assemblies 34, 36, 38 mounted on printed circuit boards 40',40",40"'. The light emitting diode assemblies 34, 36, 38 are received within a corresponding recess 42 formed in the lens 16". The printed circuit boards 40',40",40''' may be connected in parallel or series. In Fig. 4 the printed circuit boards 40',40",40''' are mounted on a substrate or plate 44.

In an alternative embodiment of the lens 16" the printed circuit boards 40',40",40"' may be received in individual recesses, and the lens 16" may be shaped so as to provide an optical guide assembling or compiling the light emitted by the light emitting diode assemblies 34, 36, 38, so that the light emitted by the lens 16" is

The printed circuit boards 40',40",40'" may have characteristics similar to those discussed with reference to Figs. 1-3.

The light emitting diode assemblies 34, 36, 38 may comprise light emitting diodes having the same light emitting characteristics or at least one of the light emitting diodes may have different light emitting characteristics than the other light emitting diodes.

In Fig. 5, the lamp 10 as illustrated in Fig. 2 is shown in an exploded view from the opposite side.

## Claims

1. A lamp including:
a light source comprising:
a printed circuit board defining planar parallel first and second surfaces, said first surface of said printed circuit board including solder pads for providing electrical connections to a power source,
a light emitting diode mounted on said first side of said printed circuit board, said light emitting diode emitting light within a specific wavelength interval, said light emitting diode being electrically connected to said solder pads,
a heat sink having a planar surface, said first side of said heat sink mounted on said second surface of said printed circuit board, said heat sink being in thermal communication with said light emitting diode,
a first lens mounted on said first surface of said printed circuit board covering said light emitting diode, said first lens substantially concentrating said light emitted from said light emitting diode so that said concentrated light emitted is substantially perpendicular to said first surface of said printed circuit board,
a second lens defining first and second opposite sides, said second lens including a recess adapted for receiving said first lens at said first side thereof, said recess receiving said concentrated light, and
said second lens providing a distribution of said concentrated light in a specific distribution at said second side of said second lens.

2. A lamp according to claim 1 where said wavelength interval defines light of a substantially white, warm white or yellow colour.

3. A lamp according to claim 1 or 2, wherein said printed circuit board is bonded to said second lens by means of an adhesive.

4. A lamp according to claim 3, wherein said adhesive being cured by light or heat.

5. A lamp according to any of the preceding claims wherein said second lens is made from an optical grade acrylic plastic.

6. A lamp according to any of the preceding claims, further comprising a electrical transformer connectable to an AC mains supply, such as a 110V 60Hz or 230V 50Hz mains supply, for transforming electrical power supplied from said mains supply to 10 V DC current.

7. A lamp assembly including:
a light source comprising:
a printed circuit board defining planar parallel first and second surfaces, said first surface of said printed circuit board including solder pads for providing electrical connections to a power source,
a light emitting diode mounted on said first side of said printed circuit board, said light emitting diode emitting light within a specific wavelength interval, said light emitting diode being electrically connected to said solder pads,
a heat sink having a planar surface, said first side of said heat sink mounted on said second surface of said printed circuit board, said heat sink being in thermal communication with said light emitting diode,
a first lens mounted on said first surface of said printed circuit board covering said light emitting diode, said first lens substantially concentrating said light emitted from said light emitting diode so that said concentrated light emitted is substantially perpendicular to said first surface of said printed circuit board,
a second lens defining first and second opposite sides, said second lens including a recess adapted for receiving said first lens at said first side thereof, and
an adhesive for fixating said light source relative to said second lens at said first side thereof, said recess receiving said concentrated light, said second lens providing a distribution of said concentrated light in a specific distribution at said second side of said second lens.

8. A lamp including:
a plurality of light sources, each comprising:
a printed circuit board defining planar parallel first and second surfaces, said first surface of said printed circuit board including solder pads for providing electrical connections to a power source,
a light emitting diode mounted on said first side of said printed circuit board, said light emitting diode emitting light within a specific wavelength interval, said light emitting diode being electrically connected to said solder pads,
a heat sink having a planar surface, said first side of said heat sink mounted on said second surface of said printed circuit board, said heat sink being in thermal communication with said light emitting diode,
a first lens mounted on said first surface of said printed circuit board covering said light emitting diode, said first lens substantially concentrating said light emitted from said light emitting diode so that said concentrated light emitted is substantially perpendicular to said first surface of said printed circuit board,
a second lens defining first and second opposite sides, said second lens including a specific recess or a plurality of recesses corresponding to said plurality of light sources at said first side thereof, said specific recess adapted for receiving said plurality of light sources or each of said recesses adapted for receiving a specific first lens of a specific light source, respectively, and
said second lens providing a distribution of said concentrated light in a specific distribution at said second side of said second lens.

9. A lamp assembly according to claim 7 further comprising any of the features of claims 2-6.

10. A lamp assembly according to claim 8 further comprising any of the features of claims 2-6.
